# EUROPEAN PATENT APPLICATION

(11) **EP 4 647 620 A1**
(43) Date of publication of application: **12.11.2025**
(21) Application number: 24824929.4
(22) Date of filing: 08.03.2024
(51) Int. Cl.: F16C 11/04, F16C 11/10, H04M 1/02

(54) **ROTATING SHAFT ASSEMBLY, HINGE DEVICE AND FOLDABLE ELECTRONIC DEVICE**

(30) Priority: 19.06.2023 CN 202310731817
(71) Applicant: Honor Device Co., Ltd., Shenzhen, Guangdong 518040 (CN)
(72) Inventor: YANG, Desen, Shenzhen, Guangdong 518040 (CN); ZANG, Yongqiang, Shenzhen, Guangdong 518040 (CN); WU, Ling, Shenzhen, Guangdong 518040 (CN); HUO, Guoliang, Shenzhen, Guangdong 518040 (CN)
(74) Representative: Gill Jennings & Every LLP
(86) International application number: PCT/CN2024/080804
(87) International publication number: WO 2024/260027

(57) **Abstract**

This application provides a rotary shaft assembly, a hinge apparatus, and a foldable electronic device. A cam group of the rotary shaft assembly includes a first cam and a second cam, and the first cam and the second cam are in mutual contact and extrusion, and can rotate relative to each other. A protruding part is disposed on the first cam, a recessed part is disposed on the second cam, and the recessed part has a sliding surface. When the first cam rotates relative to the second cam, the protruding part always slides on the sliding surface of a corresponding recessed part. The sliding surface is inclined relative to a plane perpendicular to an axis of a connecting shaft, and extends, from a first end to a second end, toward a direction away from the first cam in a direction of the axis of the connecting shaft. When the foldable electronic device is in a closed state, the protruding part abuts against the first end of the corresponding sliding surface. When the foldable electronic device is in an open state, each protruding part abuts against the second end of the corresponding sliding surface. The rotary shaft assembly provided in this application can rotate automatically, so that the foldable electronic device can automatically pup up from the closed state to the open state, which makes it more convenient and effort-saving.

## Description

This application claims priority to Chinese Patent Application No. 202310731817.5, filed with the China National Intellectual Property Administration on July 19, 2023 and entitled "ROTARY SHAFT ASSEMBLY, HINGE APPARATUS, AND FOLDABLE ELECTRONIC DEVICE", which is incorporated herein by reference in its entirety.

### TECHNICAL FIELD

This application relates to the field of rotary shaft technologies, and in particular, to a rotary shaft assembly, a hinge apparatus, and a foldable electronic device.

### BACKGROUND

A foldable electronic device (for example, a foldable-screen mobile phone) can switch freely between an unfolded state and a folded state, and has both portability and a large screen display effect, and is increasingly popular in the market. A hinge apparatus is a core structure for the foldable electronic device to implement a folding and unfolding function, and includes a rotary shaft assembly inside. Two cams that can rotate relative to each other are disposed in the rotary shaft assembly. Two components of the foldable electronic device are respectively connected to the two cams through a structure such as a damping swing arm, to drive relative rotation between the two components through relative rotation between the two cams, thereby implementing the folding and unfolding function.

In the conventional technology, a damping structure is usually designed between the two cams of the rotary shaft assembly, that is, an uneven concave-convex structure is designed on a surface on which the two cams are in contact, and axial pressure is applied to cause the two cams to extrude each other. In a process in which the cams rotate relative to each other, surfaces on which the two cams are in contact are in mutual friction. When an angle at which the cams rotate relative to each other varies, parts that are of the cams and that are in contact change, and friction force changes correspondingly, thereby providing a hand feeling that continuously changes with a product folding and unfolding angle. However, in a foldable electronic device in a current market, design of rotary shaft damping force is usually considered for a rotary shaft assembly only when a product is manually folded or unfolded, which makes it difficult to use the rotary shaft assembly.

### SUMMARY

Embodiments of this application provide a rotary shaft assembly, a hinge apparatus, and a foldable electronic device, to resolve a problem in the conventional technology that design of rotary shaft damping force is usually considered for a rotary shaft assembly only when a product is manually folded or unfolded, which makes it difficult to use the rotary shaft assembly.

An embodiment of this application provides a rotary shaft assembly used for a foldable electronic device, including a connecting shaft, at least one cam group, and an elastic member. Each of the at least one cam group includes a first cam and a second cam that are in mutual contact and extrusion, the first cam and the second cam are sequentially sleeved on the connecting shaft in a direction of an axis of the connecting shaft, and the first cam and the second cam are configured to: be capable of generating relative rotation around the axis of the connecting shaft, and be capable of generating relative movement in the direction of the axis of the connecting shaft, so that the first cam can move switching between a first position and a second position relative to the second cam.

At least one protruding part protruding outward in the direction of the axis of the connecting shaft is disposed on an end surface that is of the first cam and that faces the second cam, and at least one recessed part recessed inward in the direction of the axis of the connecting shaft is disposed on an end surface that is of the second cam and that faces the first cam, where the at least one protruding part is in a one-to-one correspondence with the at least one recessed part, and each of the at least one recessed part has a sliding surface for sliding by a corresponding protruding part, so that when the first cam moves switching between the first position and the second position relative to the second cam, each of the at least one protruding part always slides on the sliding surface of a corresponding recessed part.

In addition, the sliding surface is configured to be disposed inclined relative to a plane perpendicular to the axis of the connecting shaft, the sliding surface has a first end and a second end, and from the first end to the second end, the sliding surface extends toward a direction away from the first cam in the direction of the axis of the connecting shaft.

When the first cam is in the first position relative to the second cam, each of the at least one protruding part abuts against the first end of the sliding surface of the corresponding recessed part, and the foldable electronic device is in a closed state; and when the first cam is in the second position relative to the second cam, each of the at least one protruding part abuts against the second end of the sliding surface of the corresponding recessed part, and the foldable electronic device is in an open state.

According to the rotary shaft assembly provided in this application, the first cam and the second cam can rotate relative to each other, and drive two components of the foldable electronic device to rotate relative to each other, to switch between the closed state (that is, a folded state) and the open state (that is, an unfolded state). An uneven concave-convex structure is designed on end surfaces that are of the first cam and the second cam and that are opposite to each other. The protruding part protruding outward is disposed on the first cam, and the recessed part recessed inward is disposed on the second cam. When the two cams rotate relative to each other, the protruding part slides on the sliding surface in the recessed part corresponding to the protruding part, and damping force changes through design of the sliding surface.

Further, the sliding surface is inclined relative to the plane perpendicular to the axis of the connecting shaft, and from the first end to the second end, the sliding surface extends toward the direction away from the first cam in the direction of the axis of the connecting shaft, that is, the sliding surface is a surface inclined relative to a radial direction of the connecting shaft as a whole, and from the first end to the second end, the sliding surface always extends toward the direction away from the first cam. This may be understood as that a process in which a cam slides from the first end to the second end along the sliding surface is always a downhill path. In this structure, when the foldable electronic device is in the closed state, the protruding part abuts against the first end of the sliding surface. Because elastic force of the elastic member causes mutual extrusion between the first cam and the second cam, the protruding part has a tendency of moving toward the second cam. In this case, as long as locking force that keeps the foldable electronic device in the closed state is released, the protruding part on the first cam automatically slides from the first end to the second end along the downhill path, the first cam rotates from the first position to the second position relative to the second cam, and the foldable electronic device automatically switches from the closed state to the open state.

Therefore, the rotary shaft assembly provided in this embodiment of this application can rotate automatically, so that the foldable electronic device can automatically switch from the closed state to the open state, to implement automatic pop-up, thereby making it more convenient and effort-saving during use.

In some embodiments, each of the at least one recessed part includes a first inclined surface and a second inclined surface that are connected, both the first inclined surface and the second inclined surface are inclined relative to the plane perpendicular to the axis of the connecting shaft, the first end of the sliding surface is located on the first inclined surface, the second end of the sliding surface is located on the second inclined surface, and a surface that is in the first inclined surface and the second inclined surface and that is located between the first end and the second end forms the sliding surface.

In the foregoing solution, because phases in which the foldable electronic device switches between the open state and the closed state have different requirements for a hand feeling, a design structure that divides the sliding surface into two inclined surfaces facilitates hand feeling design in the phases.

In some embodiments, an angle at which the first inclined surface is inclined relative to the plane perpendicular to the axis of the connecting shaft is 10°-15°, and an angle at which the second inclined surface is inclined relative to the plane perpendicular to the axis of the connecting shaft is 60°-65°.

In the foregoing solution, a relatively small inclined angle is designed for the first inclined surface, so that it is relatively effort-saving when the protruding part moves toward the second end of the sliding surface on the second inclined surface, and it is relatively effort-saving in a later phase in which the foldable electronic device switches from the open state to the closed state. When the foldable electronic device is in the open state, the first cam is in the second position relative to the second cam, and the protruding part fits with the second inclined surface. A relatively large inclined angle is designed for the second inclined surface, which can prevent the protruding part from moving toward the first end of the sliding surface along the second inclined surface under slight external force (for example, bump and vibration of the foldable electronic device), resulting in accidental switching of the foldable electronic device to the closed state, that is, force for keeping the foldable electronic device in the open state is increased.

In some embodiments, when each protruding part of the first cam moves along the recessed part from the second end of the sliding surface to a junction between the first inclined surface and the second inclined surface, an angle of relative rotation between the first cam and the second cam is 20°-30°.

Because the inclined angle of the second inclined surface is relatively large, it is relatively laborious for the protruding part to move on the second inclined surface. This part is designed as a relatively short route to reduce phases that are laborious in a process of relative rotation between the first cam and the second cam.

In some embodiments, the first inclined surface and the second inclined surface are connected by using a first arc surface, so that sliding of the protruding part between the first inclined surface and the second inclined surface is continuous relatively smoothly.

In some embodiments, an end that is of the first inclined surface and that is away from the second inclined surface is disposed spaced apart from the first end of the sliding surface, and a specific distance is reserved between the first end of the sliding surface and the end that is of the first inclined surface and that is away from the second inclined surface as redundancy, thereby reducing a processing precision requirement of the second cam.

In some embodiments, an end that is of the second inclined surface and that is away from the first inclined surface is disposed spaced apart from the second end of the sliding surface, and a specific distance is reserved between the second end of the sliding surface and the end that is of the second inclined surface and that is away from the first inclined surface as redundancy, thereby reducing a processing precision requirement of the second cam.

In some embodiments, when each protruding part moves along the recessed part corresponding to the protruding part from the second end of the sliding surface to the end that is of the second inclined surface and that is away from the first inclined surface, an angle of relative rotation between the first cam and the second cam is 3°-10°.

In some embodiments, each recessed part further includes a bottom surface connected to the end that is of the second inclined surface and that is away from the first inclined surface, and when the protruding part abuts against the second end of the sliding surface of the recessed part, there is a gap between the protruding part and the bottom surface. Lubricant grease may be added to the gap, to reduce friction force in relative rotation between the first cam and the second cam, so that a process of relative rotation between the first cam and the second cam is smoother.

In some embodiments, the recessed part further includes a side surface that is connected to an end that is of the bottom surface and that is away from the second inclined surface, and when the protruding part abuts against the second end of the sliding surface of the recessed part, the protruding part further abuts against the side surface of the recessed part, to limit relative rotation between the first cam and the second cam.

In the foregoing solution, when the first cam rotates relative to the second cam to the second position, a first curved surface of the protruding part abuts against the second inclined surface of the recessed part, and a third connection surface of the protruding part abuts against the side surface of the recessed part, so that the entire protruding part is clamped in the recessed part, to prevent continuous rotation between the first cam and the second cam. In this case, a preset rotation angle is reached between the first cam and the second cam, that is, the side surface of the recessed part plays a role of limiting a rotation route of the first cam.

In some embodiments, the bottom surface is configured as an inclined surface that is inclined relative to the plane perpendicular to the axis of the connecting shaft, to help reserve a gap between the bottom surface and the protruding part.

In some embodiments, in a process in which each protruding part moves from the first position to the second position, the protruding part keeps in line contact with the sliding surface of the corresponding recessed part, to reduce friction between the first cam and the second cam.

In some embodiments, the protruding part has a first connection surface, a second connection surface, and a third connection surface that are sequentially connected, the second connection surface is located on a side that is of an end surface of the first cam and that is close to the second cam, both one end of the first connection surface and one end of the third connection surface are connected to the end surface of the first cam, and the other ends are respectively connected to two ends of the second connection surface. The second connection surface is connected to the first connection surface by using a first curved surface, and in a process in which each protruding part moves from the first position to the second position, the first curved surface and the second connection surface abut against the sliding surface of the corresponding recessed part.

Because the first curved surface is a curved surface as a whole, and both the first inclined surface and the second inclined surface on the recessed part are planes, the first curved surface and the sliding surface may always keep in line contact. A part that is on the second connection surface and that is in contact with the sliding surface is disposed as a curved surface or an arc surface, so that the second connection surface and the sliding surface can also keep in line contact.

In some embodiments, when the first cam moves from the first position to the second position relative to the second cam, an angle of relative rotation between the first and second cams is 85°-95°.

In some embodiments, the at least one protruding part is three protruding parts evenly disposed at intervals in a circumferential direction of the first cam, and the at least one recessed part is three recessed parts evenly disposed at intervals in a circumferential direction of the second cam, so that an area of contact between the first cam and the second cam can be increased, and the first cam and the second cam are more stable when rotating relative to each other.

In some embodiments, the rotary shaft assembly further includes an elastic member, and the elastic member is sleeved on the connecting shaft. The elastic member is disposed at an end that is of the first cam and that is away from the second cam, the second cam is fastened relative to the connecting shaft in the direction of the axis of the connecting shaft, and the elastic member is configured to apply elastic force to the first cam through deformation of the elastic member, so that the first cam and the second cam are in mutual contact and extrusion; or the elastic member is disposed at an end that is of the second cam and that is away from the first cam, the first cam is fastened relative to the connecting shaft in the direction of the axis of the connecting shaft, and the elastic member is configured to apply elastic force to the second cam through deformation of the elastic member, so that the first cam and the second cam are in mutual contact and extrusion.

In some embodiments, the at least one cam group is two cam groups respectively disposed at two ends of the elastic member, the second cam in each of the two cam groups is disposed between the elastic member and the first cam in the cam group, and the elastic member simultaneously provides mutual extrusion force between the first cam and the second cam for the two cam groups.

An embodiment of this application further provides a hinge apparatus, including the rotary shaft assembly provided in any one of the foregoing embodiments. Each rotary shaft assembly in the hinge apparatus can rotate automatically, which makes it more convenient to effort-saving during use.

An embodiment of this application further provides a foldable electronic device, including a housing assembly. The housing assembly includes a first housing and a second housing, the housing assembly further includes the hinge apparatus provided in any one of the foregoing embodiments, and the first housing is rotatably connected to the second housing by using the hinge apparatus, so that the foldable electronic device can switch between a closed state and an open state. The foldable electronic device can automatically switch from the closed state to the open state, which is more convenient.

In some embodiments, the hinge apparatus includes at least one group of rotary shaft assemblies, each group of rotary shaft assemblies includes two rotary shaft assemblies symmetrically disposed, each rotary shaft assembly further includes a damping swing arm, one end of the damping swing arm has a rotating part, and the rotating part is configured as the first cam. The other end of the damping swing arm of one rotary shaft assembly in each group of rotary shaft assemblies is connected to the first housing, and the other end of the damping swing arm of the other rotary shaft assembly is connected to the second housing. The foldable electronic device further includes a locking mechanism. When the locking mechanism is in a locked state, the first housing and the second housing are stacked and kept relatively fixed, and when the locking mechanism is in an unlocked state, the first housing and the second housing can rotate relative to each other.

In some embodiments, the foldable electronic device further includes a display screen, and the display screen is laid on a side of the housing assembly. When the foldable electronic device is in the closed state, the display screen surrounds the outside of the housing assembly.

### BRIEF DESCRIPTION OF DRAWINGS

FIG. 1 is a schematic diagram of a structure of a foldable electronic device in an open state according to an embodiment of this application;
FIG. 2A is a schematic diagram of a structure in which a foldable electronic device switches from an open state to a closed state according to an embodiment of this application;
FIG. 2B is a schematic diagram of a structure of a foldable electronic device in a closed state according to an embodiment of this application;
FIG. 3A is a schematic diagram of a three-dimensional structure of a hinge apparatus according to an embodiment of this application;
FIG. 3B is a locally enlarged view of a part X in FIG. 3A;
FIG. 4A-FIG. 4B are schematic diagrams of partial structures of a rotary shaft assembly, where FIG. 4B is a locally enlarged view of a part Y in FIG. 4A;
FIG. 5 is a schematic diagram of a structure in which a concave cam in a rotary shaft assembly expands in a circumferential direction;
FIG. 6 is a schematic diagram of a three-dimensional structure of a rotary shaft assembly according to an embodiment of this application;
FIG. 7 is a schematic diagram of a three-dimensional structure of a rotary shaft assembly in another implementation according to an embodiment of this application;
FIG. 8A-FIG. 8D are schematic diagrams of structures of a second cam in a rotary shaft assembly according to an embodiment of this application, where FIG. 8B is a locally enlarged view of a part Z in FIG. 8A;
FIG. 9A is a schematic diagram of a 120° structure in which a second cam in a rotary shaft assembly expands in a circumferential direction according to an embodiment of this application;
FIG. 9B is a schematic diagram of a 360° structure in which a second cam in a rotary shaft assembly expands in a circumferential direction according to an embodiment of this application;
FIG. 10A is a schematic diagram of a 120° structure in which a second cam in a rotary shaft assembly expands along an axis in another implementation according to an embodiment of this application;
FIG. 10B is a schematic diagram of a 360° structure in which a second cam in a rotary shaft assembly expands along an axis in another implementation according to an embodiment of this application;
FIG. 11A-FIG. 11C are schematic diagrams of structures of a first cam in a rotary shaft assembly according to an embodiment of this application;
FIG. 12A is a schematic diagram of a 120° structure in which a first cam in a rotary shaft assembly expands in a circumferential direction according to an embodiment of this application;
FIG. 12B is a schematic diagram of a 360° structure in which a first cam in a rotary shaft assembly expands in a circumferential direction according to an embodiment of this application;
FIG. 13A-FIG. 13B are schematic diagrams of fitting that is between a first cam and a second cam in a rotary shaft assembly and that is in a first position according to an embodiment of this application;
FIG. 14A-FIG. 14B are schematic diagrams of fitting that is between a first cam and a second cam in a rotary shaft assembly and that is between a first position and a second position according to an embodiment of this application;
FIG. 15A-FIG. 15B are schematic diagrams of fitting that is between a first cam and a second cam in a rotary shaft assembly and that is in a second position according to an embodiment of this application;
FIG. 16A-FIG. 16C are schematic diagrams of structures of a group of rotary shaft assemblies according to an embodiment of this application;
FIG. 17 is a locally enlarged view of a part Q in FIG. 16C; and
FIG. 18A-FIG. 18B are schematic diagrams of structures of two adjacent second cams in a group of rotary shaft assemblies according to an embodiment of this application.

### Descriptions of reference numerals:

In a conventional technology:
100': rotary shaft assembly; 1': connecting shaft; 2': cam; 21': protruding part; and
3': concave cam; 31': recessed part; 311': first inclined surface; 312': flat grinding surface; and 313': second inclined surface.

In this application:
100: rotary shaft assembly; 1: connecting shaft; 2: cam group;
21: first cam; 210: protruding part; 211: first connection surface; 212: second connection surface; 213: third connection surface;
214: first curved surface; 215: second curved surface;
22: second cam; 220: recessed part; 221: sliding surface; 221a: first end; 221b: second end;
223: first inclined surface; 223a: first end; 223b: second end;
224: second inclined surface; 224a: first end; 224b: second end;
225: first arc surface; 226: bottom surface; 227: side surface;
3: elastic member; 4: damping swing arm; 41: rotating part; 42: abutment part;
200: hinge apparatus; 50: base; 51: first connecting plate; 52: second connecting plate;
6: abutment seat; 7: synchronization mechanism; 71: first gear; 72: second gear;
300: foldable electronic device; 8: housing assembly; 81: first housing; 810: side surface;
82: second housing; 820: side edge part; 821: side surface; 83: buckle; 84: slot; 85: button;
9: display screen; 91: first part; 92: second part; 93: foldable part; and
M: axis of the connecting shaft; and S: gap.

### DESCRIPTION OF EMBODIMENTS

The implementations of this application are described below by using specific embodiments, and a person skilled in the art can easily understand other advantages and effects of this application from the content disclosed in this specification. Although the description of this application is described with reference to some embodiments, this does not represent that features of this application are limited to this implementation. On the contrary, the purpose of the description of the application with reference to the implementation is to cover other options or modifications that may be extended based on the claims of this application. To provide a deep understanding of this application, the following description includes many specific details. This application can also be implemented without using these details. In addition, to avoid confusing or obscuring the focus of this application, some specific details are omitted from the description. It should be noted that the embodiments in this application and the features in the embodiments can be combined with each other in a case that no conflict occurs.

It should be noted that in this specification, similar reference numerals and letters indicate similar items in the following accompanying drawings. Therefore, once an item is defined in one accompanying drawing, the item does not need to be further defined and explained in the subsequent accompanying drawings.

In the description of this application, it should be noted that an orientation or positional relationship indicated by terms "center", "top", "bottom", "left", "right", "vertical", "horizontal", "inner", "outer", and the like is based on an orientation or positional relationship shown in the accompanying drawings, and is only for the convenience of describing this application and simplifying the description, rather than indicating or implying that the indicated apparatus or component must have a specific orientation or must be constructed and operated in a specific orientation. Therefore, the orientation or positional relationship should not be construed as a limitation on this application. In addition, the terms "first" and "second" are used for description only, and cannot be construed as indicating or implying relative importance.

In the description of this application, it should be noted that, unless otherwise expressly specified and defined, the terms "install", "connection", and "connected to" should be understood in a broad sense. For example, the connection can be a fixed connection, a detachable connection, or an integral connection; can be a mechanical connection or an electrical connection; or can be a direct connection, an indirect connection through an intermediate medium, or an internal connection between two elements. A person of ordinary skill in the art can understand specific meanings of the foregoing terms in this application based on specific cases.

In the description of this application, it should be noted that, "perpendicular to each other" in this application is not "absolute perpendicular", and "approximate perpendicular" caused by a processing error and an assembly error (for example, an angle between two structural features is 89.9°) is also within a range of "perpendicular to each other" in this application. "Parallel to each other" in this application is also not "absolute parallel", and "approximate parallel" caused by a processing error and an assembly error (for example, an angle between two structural features is 0.1°) is also within the scope of "parallel to each other" in this application. "Axially symmetrical" in this application is not "absolute axially symmetrical", and "approximate axially symmetrical" caused by a processing error and an assembly error (for example, a part of structure deviates from an axis of symmetry by a specific distance or angle) is also within the scope of "axially symmetrical" in this application. "Centrally symmetrical" in this application is not "absolute centrally symmetrical", and "approximate centrally symmetrical" caused by a processing error and an assembly error (for example, a part of structure deviates from an axis of symmetry by a specific distance or angle) is also within the scope of "centrally symmetrical" in this application. This is not specifically limit in this application.

To make the objectives, technical solutions, and advantages of this application clearer, the following further describes implementations of this application in detail with reference to the accompanying drawings.

Embodiments of this application provide a foldable electronic device. The foldable electronic device may be but is not limited to a foldable-screen mobile phone, a foldable tablet computer, a foldable notebook computer, a foldable display, a personal digital device, an intelligent wearable device, and the like. The following uses a foldable-screen mobile phone as an example to describe a structure of the foldable electronic device.

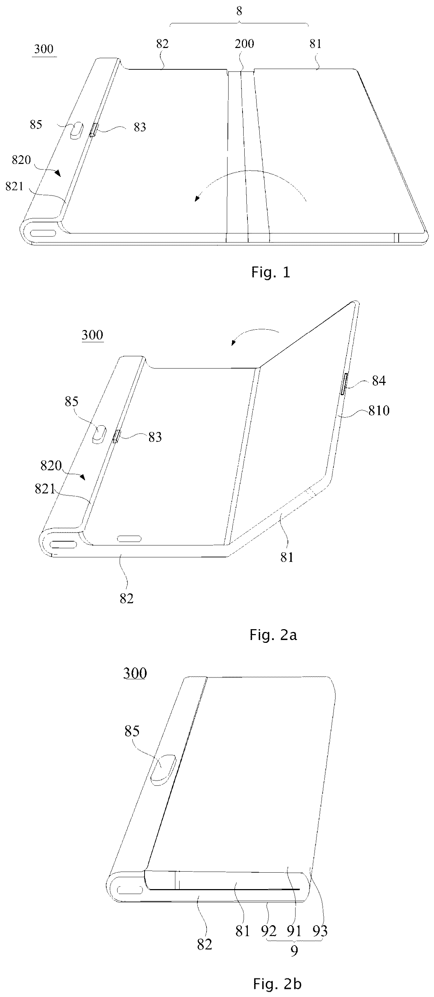

Referring to FIG. 1-FIG. 2B, FIG. 1 is a schematic diagram of a structure of a foldable electronic device in an open state according to an embodiment of this application; FIG. 2A is a schematic diagram of a structure in which a foldable electronic device switches from an open state to a closed state according to an embodiment of this application; and FIG. 2B is a schematic diagram of a structure of a foldable electronic device in a closed state according to an embodiment of this application.

As shown in FIG. 1-FIG. 2B, a foldable electronic device 300 includes a first housing 81, a second housing 82, and a hinge apparatus 200. The first housing 81 is rotatably connected to the second housing 82 by using the hinge apparatus 200. In different use scenarios, the foldable electronic device 300 may be in different use states. FIG. 1 shows a foldable electronic device 300 in an open state (which may be understood as an unfolded state). FIG. 2B shows a foldable electronic device 300 in a closed state (which may be understood as a folded state). When the foldable electronic device 300 is in the open state, an angle at which the foldable electronic device is opened is 180°, that is, an angle between the first housing 81 and the second housing 82 is 180°. It may be understood by a person skilled in the art that, an open angle of the foldable electronic device 300 may be 90°, 120°, 210°, or the like. This is not limited in this application. In addition, each angle described as an example in this application allows a slight deviation. For example, when the foldable electronic device 300 is in the open state, the angle at which the foldable electronic device is opened may be 180°, or may be approximately 180°, for example, 170°, 175°, 185°, or 190°. Another angle may also have the same understanding in the following.

Further, both the first housing 81 and the second housing 82 may rotate around the hinge apparatus 200, so that the first housing 81 and the second housing 82 rotate relative to each other. When the first housing 81 and the second housing 82 rotate relative to each other to be coplanar, the foldable electronic device is in the open state shown in FIG. 1. In this case, an angle between the first housing 81 and the second housing 82 is 180°. When the first housing 81 and the second housing 82 rotate relative to each other to be mutually stacked, the foldable electronic device 300 is in the closed state shown in FIG. 2B. In this case, an angle between the first housing 81 and the second housing 82 may be approximately considered as 0°.

A person skilled in the art may understand that a specific structure of the foldable electronic device 300 is not limited in this application. For example, the foldable electronic device 300 may further include various electronic components. The first housing 81, the second housing 82, and the hinge apparatus 200 jointly form a housing assembly 8 of the foldable electronic device 300, to provide protection and support for various electronic components and other structures. To facilitate understanding of a folding process and a use scenario of a foldable electronic device, the following describes, by using an example, a structure possibly used for the foldable electronic device.

As shown in FIG. 1-FIG. 2B, in an implementation, the foldable electronic device 300 further includes a display screen 9. The display screen 9 is laid on a side of the housing assembly 8. The display screen 9 may be but is not limited to an organic light-emitting diode (organic light-emitting diode, OLED) display screen, an active-matrix organic light-emitting diode or an active-matrix organic light-emitting diode (active-matrix organic light-emitting diode, AMOLED) display screen, a quantum dot light emitting diode (quantum dot light emitting diodes, QLED) display screen, or the like. This is not limited in this application. The display screen 9 is connected to a side surface of the housing assembly 8, and a side surface that is of the display screen 9 and that is away from the housing assembly 8 is a display surface of the display screen. The display surface is configured to display information and provide an interaction interface for a user.

Further, the display screen 9 includes a first part 91, a second part 92, and a foldable part 93. The first part 91 is connected to the first housing 81, the second part 92 is connected to the second housing 82, and the foldable part 93 is located between the first part 91 and the second part 92. During use of the foldable electronic device 300, the first part 91 and the second part 92 always keep in a planar state, and the foldable part 93 may be bent to change an angle between the first part 91 and the second part 92, so that the display screen 9 is folded or unfolded with movement of the housing assembly 8, and the foldable electronic device 300 switches between a folded state and an unfolded state. For example, in the display screen 9, at least the foldable part 93 is made of a flexible material, so that the foldable part 93 can be bent.

Under driving of the hinge apparatus 200, the display screen 9 is opened or closed together with the first housing 81 and the second housing 82. The foldable part 93 of the display screen 9 is flattened or bent, so that the first part 91 and the second part 92 rotate relative to each other. When the foldable electronic device 300 is in the open state, the first part 91 and the second part 92 are in an unfolded state in which the first part and the second part are relatively away from each other, the foldable part 93 is flattened, and display surfaces of the first part 91 and the second part 92 face a same direction. When the foldable electronic device 300 is in the closed state, the first part 91 and the second part 92 are stacked relative to each other, the foldable part 93 is in a bent state, and display surfaces of the first part 91 and the second part 92 are opposite to or away from each other.

It should be noted that the foldable electronic device 300 provided in this application may be an outward folded electronic device or an inward folded electronic device. As shown in FIG. 1-FIG. 2B, in an implementation, the foldable electronic device 300 is an outward folded electronic device. When the outward folded electronic device is in the closed state, the display screen 9 surrounds the outside of the housing assembly 8. Alternatively, this may be understood as follows: The first part 91 and the second part 92 of the display screen 9 are disposed away from each other, the housing assembly 8 is located between the first part 91 and the second part 92, and display surfaces of the first part 91 and the second part 92 are exposed to a user.

In an example scenario, when the foldable electronic device 300 is an inward folded electronic device, and is in the closed state, the first part 91 and the second part 92 of the display screen 9 are opposed to each other, the display screen 9 is accommodated inside the housing assembly 8 as a whole, the housing assembly 8 protects the outside of the display screen 9, and a user cannot see the display surface of the display screen 9 from an appearance.

In an implementation, both the first housing 81 and the second housing 82 have accommodating space inside to accommodate some electronic components. The electronic components include but are not limited to a circuit board, a battery, a camera module, a microphone, a speaker, and the like. This is not limited in this application.

In an implementation, the foldable electronic device further includes a locking mechanism (for example, a structure that is shown in FIG. 1 and FIG. 2A and in which a buckle fits with a slot). The locking mechanism can switch between a locked state and an unlocked state. When the locking mechanism is in the locked state, the first housing 81 and the second housing 82 are stacked and kept relatively fixed, that is, the foldable electronic device 300 is kept in the closed state by using the locking mechanism, to improve stability of the foldable electronic device. When the locking mechanism is in the unlocked state, the first housing 81 and the second housing 82 can rotate relative to each other.

A specific type and a structure of the locking mechanism are not limited. As shown in FIG. 1 to FIG. 2B, for example, the locking mechanism may be a buckle fitting structure, and includes a buckle 83, a slot 84, and a button 85. The buckle 83 is scalably installed on a side edge part 820 that is of the second housing 82 and that is away from the hinge apparatus 200. The button 85 is also installed on the side edge part 820 of the second housing 82, and an extension and contraction state of the buckle 83 may be adjusted by pressing the button 85. The slot 84 may be disposed on a side surface 810 that is of the first housing 81 and that is away from the hinge apparatus 200.

As shown in FIG. 1, when the foldable electronic device 300 is in the open state, the buckle 83 is separated from the slot 84 (refer to FIG. 2A), and the buckle 83 extends from the side edge part 820 of the second housing 82, and protrudes from a side surface 821 that is of the side edge part 820 and that faces the hinge apparatus 200.

As shown in FIG. 2A-FIG. 2B, when the foldable electronic device 300 switches from the open state to the closed state, the first housing 81 and the second housing 82 rotate opposite to each other, and the side surface 810 of the first housing 81 is gradually close to the side surface 821 of the side edge part 820 of the second housing 82. When the first housing 81 rotates to a position abutting against the buckle 83, the buckle 83 retracts into the side edge part 820 of the second housing 82. When the first housing 81 continues to rotate to a position in which the slot 84 directly faces the buckle 83, the buckle 83 extends from the side edge part 820 of the second housing 82, and is clamped in the slot 84, so that the first housing 81 and the second housing 82 that are stacked can be kept relatively fixed, and the foldable electronic device 300 can be kept in the closed state.

As shown in FIG. 2B, and with reference to FIG. 2A for understanding, when the foldable electronic device 300 is in the closed state, the buckle 83 may be retracted into the side edge part 820 of the second housing 82 by pressing the button 85, the buckle 83 is separated from the slot 84, and the first housing 81 and the second housing 82 can rotate relative to each other. It should be noted that, when pressing force applied to the button 85 is removed, the buckle 83 can extend from the side edge part 820 of the second housing 82.

In another alternative implementation, the locking mechanism may further be a magnetic attraction component, and a magnetic attraction structure is separately disposed in the first housing 81 and the second housing 82. When the first housing 81 and the second housing 82 rotate to be closed, magnetic attraction structures on two sides attract each other, to prevent relative rotation between the first housing 81 and the second housing 82. When the foldable electronic device 300 needs to be switched to the open state, the first housing 81 or the second housing 82 is rotated by a specific angle, so that the magnetic attraction structures are separated from each other, the locking mechanism is automatically unlocked, and the first housing 81 and the second housing 82 can continue to rotate relative to each other.

In some solutions for the foldable electronic device, a user needs to manually rotate the first housing and the second housing to switch the foldable electronic device from the closed state to the open state. In this application, a rotary shaft assembly 100 in the hinge apparatus 200 is disposed in a specific structure, so that when the locking mechanism of the foldable electronic device 300 is unlocked, the first housing 81 and the second housing 82 can automatically rotate relative to each other, and the foldable electronic device 300 automatically switches from the closed state to the open state, that is, the foldable electronic device automatically pops up. For example, as shown in FIG. 1 to FIG. 2B, when the foldable electronic device 300 is in the closed state shown in FIG. 2B, the buckle 83 may be retracted into the side edge part 820 of the second housing 82 by pressing the button 85, and the buckle 83 is separated from the slot 84. Through the rotary shaft assembly 100 in this application, the foldable electronic device 300 can automatically pop up from the closed state shown in FIG. 2B to the open state shown in FIG. 1. To help understand a principle in which the hinge apparatus 200 drives the first housing 81 and the second housing 82 to rotate, the following first describes an overall structure of the hinge apparatus 200 with reference to the accompanying drawings.

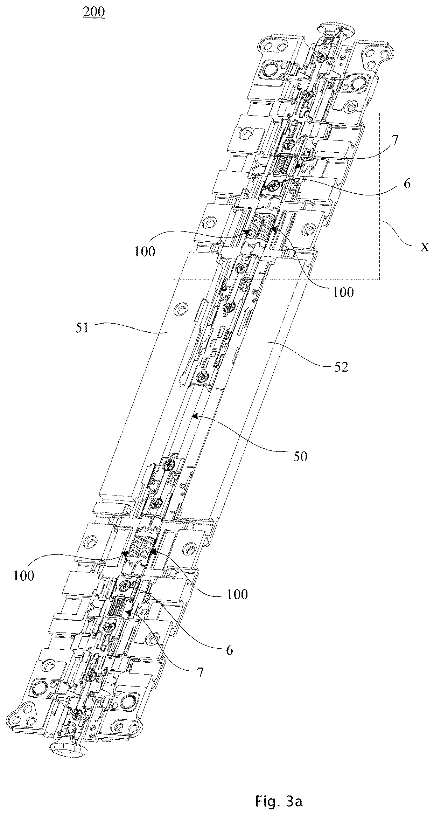

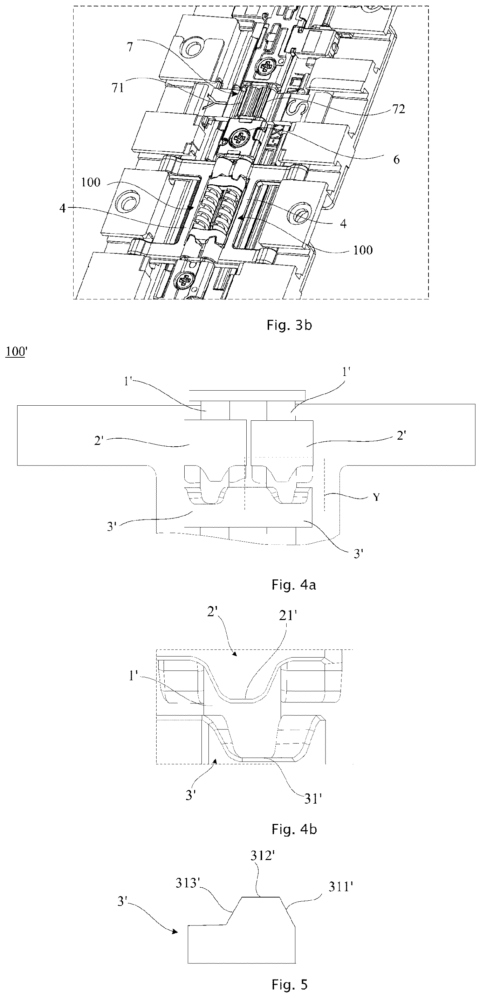

Referring to FIG. 3A-FIG. 3B, FIG. 3A is a schematic diagram of a three-dimensional structure of a hinge apparatus according to an embodiment of this application; and FIG. 3B is a locally enlarged view of a part X in FIG. 3A.

As shown in FIG. 3A-FIG. 3B, an embodiment of this application provides a hinge apparatus 200, including a base 50 and at least one group of rotary shaft assemblies. A group of rotary shaft assemblies includes two symmetrically disposed rotary shaft assemblies 100. Each rotary shaft assembly 100 includes a damping swing arm 4. One end of the damping swing arm 4 located in the rotary shaft assembly 100 on one side can rotate relative to the base 50, and the other end is connected to the first housing 81 (refer to FIG. 1-FIG. 2B). One end of the damping swing arm 4 located in the rotary shaft assembly 100 on the other side can rotate relative to the base 50, and the other end is connected to the second housing 82 (refer to FIG. 1-FIG. 2B). When the damping swing arm 4 of each rotary shaft assembly 100 rotates relative to the base 50, the first housing 81 and the second housing 82 may be driven to rotate relative to the base 50. Two damping swing arms 4 in each group of rotary shaft assemblies 100 respectively drive the first housing 81 and the second housing 82 to rotate, so that the first housing 81 and the second housing 82 rotate relative to each other. Therefore, the foldable electronic device 300 can switch between the open state and the closed state.

A manner of connection between each damping swing arm 4 and the first housing 81 or the second housing 82 is not limited. In an implementation, two connecting plates are further disposed in the hinge apparatus 200, which are respectively a first connecting plate 51 connected to the first housing 81 and a second connecting plate 52 connected to the second housing 82. Each damping swing arm 4 is connected to the first connecting plate 51 or the second connecting plate 52, to be indirectly connected to the first housing 81 or the second housing 82. In another alternative implementation, each damping swing arm 4 may be connected to the housing of the foldable electronic device 300 in other manners, which are not listed one by one in this application.

It should be noted that structures of two rotary shaft assemblies 100 in a group of rotary shaft assemblies may be the same or different. The two rotary shaft assemblies may be symmetrically disposed, or may be asymmetrically disposed. This is not limited in this application.

A person skilled in the art may understand that a quantity and a layout manner of rotary shaft assemblies 100 are not limited. In an implementation, two groups of symmetrical rotary shaft assemblies 100 are disposed in the hinge apparatus 200 in a longitudinal direction, and both the first housing 81 and the second housing 82 are connected to the two damping swing arms 4, so that force is more uniform. In another alternative implementation, one or more than two groups of rotary shaft assemblies 100 or the like may be disposed. This is not limited in this application.

In an implementation, the hinge apparatus 200 further includes a plurality of abutment seats 6 disposed on the base 50, and each abutment seat is disposed at an end of a group of rotary shaft assemblies 100, and is fixedly connected to the base 50, to limit a position of each rotary shaft assembly 100 relative to the base 50 in a longitudinal direction of the base 50. A quantity of abutment seats 6 is not limited, and generally corresponds to a quantity of rotary shaft assemblies 100. A specific structure of the abutment seat 6 and a manner of connection between the abutment seat and the base 50 are not limited. For example, the abutment seat 6 may be connected to the base 50 in a form of screwing, welding, or the like, and the abutment seat 6 may alternatively be integrally formed with the base 50 (which may alternatively be understood as that a part of the base 50 forms the abutment seat 6).

In an implementation, a plurality of synchronization mechanisms 7 may be further disposed in the hinge apparatus 200. Under transmission action of the synchronization mechanism 7, the first housing 81 and the second housing 82 can rotate synchronously relative to the base 50, thereby improving rotation experience of the foldable electronic device 300.

A specific structure of the synchronization mechanism 7 is not limited. In an implementation, the synchronization mechanism 7 includes a first gear 71 and a second gear 72. The two gears are engaged with each other, and are respectively connected to the first housing 81 and the second housing 82. The two gears are engaged with each other to implement synchronous rotation of the gears, and drive synchronous rotation between the first housing 81 and the second housing 82. In another alternative implementation, relative rotation between the first housing 81 and the second housing 82 may be driven in a plurality of transmission manners such as chain transmission and belt transmission. This is not limited in this application.

It should be noted that a quantity of synchronization mechanisms 7 is not limited. In an implementation, two synchronization mechanisms 7 are symmetrically disposed in the hinge apparatus 200. In another alternative implementation, only a single synchronization mechanism 7 may be disposed, or when a length of the hinge apparatus 200 is relatively large, more than three synchronization mechanisms 7 or the like may be disposed.

It may be understood by a person skilled in the art that, the foregoing description of the hinge apparatus 200 is merely an example, and does not impose a limitation on the hinge apparatus 200 provided in this application. Actually, the hinge apparatus 200 may include more or fewer components than those listed above.

The foregoing mainly describes the structures of the foldable electronic device 300 and the hinge apparatus 200, to generally describe a use scenario of the rotary shaft assembly 100 provided in this application. The following describes structures of rotary shaft assemblies in this application and another reference design with reference to the accompanying drawings, to better describe a technical effect that can be generated by the rotary shaft assembly provided in this application.

Referring to FIG. 4A-FIG. 5, FIG. 4A-FIG. 4B are schematic diagrams of partial structures of a rotary shaft assembly, where FIG. 4B is a locally enlarged view of a part Y in FIG. 4A; and FIG. 5 is a schematic diagram of a local structure in which a concave cam in a rotary shaft assembly expands in a circumferential direction.

As shown in FIG. 4A-FIG. 5, a rotary shaft assembly 100' includes a connecting shaft 1' and a concave cam-cam group. The concave cam-cam group includes a concave cam 3' and a cam 2' sleeved on the connecting shaft 1', and the concave cam 3' and the cam 2' may rotate relative to each other around an axis of the connecting shaft 1'. Relative rotation between the housings of the foldable electronic device may be further driven through relative rotation between the concave cam 3' and the cam 2', to switch between the closed state and the open state.

Further, end surfaces on which the concave cam 3' and the cam 2' are in contact with each other are disposed in an uneven concave-convex structure. A plurality of protruding parts 21' protruding outward are disposed on the cam 2', and a plurality of recessed parts 31' recessed inward are disposed on the concave cam 3'. The plurality of recessed parts 31' and structures connecting the plurality of recessed parts 31' form sliding surfaces that fit the plurality of protruding parts 21'. When the concave cam 2' and the cam 3' rotate relative to each other, each protruding part 21' slides on the sliding surface.

As shown in FIG. 5, each sliding surface on the concave cam 3' includes a first inclined surface 311', a flat grinding surface 312', and a second inclined surface 313' that are sequentially connected. The flat grinding surface 312' is a plane perpendicular to the axis of the connecting shaft 1', and both the first inclined surface 311' and the second inclined surface 313' are inclined surfaces inclined relative to the flat grinding surface 312'. In a process of relative rotation between the concave cam 3' and the cam 2', the cam 2' first moves along one of the inclined surfaces, further moves along the flat grinding surface 312', and then moves along the other inclined surface. Regardless of a specific moving process, the cam 2' needs to first go uphill along one of the inclined surfaces, needs to overcome mutual extrusion force and friction force between the concave cam 3' and the cam 2', and needs to rotate relying on external force. For example, when the rotary shaft assembly 100' is applied to the foldable electronic device, and the foldable electronic device is in the closed state, the locking mechanism is unlocked. In this case, the protruding part 21' on the cam 2' is clamped in the corresponding recessed part 31' on the concave cam 3'. To implement relative rotation between the concave cam 3' and the cam 2', the protruding part 21' needs to first slide along the first inclined surface 311', and rises from a bottom to a top of the first inclined surface 311' to enter the flat grinding surface 312'. Because the cam 2' and the concave cam 3' mutually extrude toward each other, during rotation, the protruding part 21' needs to overcome extrusion force, and friction force between the protruding part 21' and the first inclined surface 311'. Therefore, one housing of the foldable electronic device needs to be manually rotated, to force the concave cam and the cam to rotate relative to each other. However, auto-rotation between the concave cam and the cam cannot be implemented, that is, the foldable electronic device cannot automatically pop up. As a result, it is difficult to use the foldable electronic device.

Based on this, this application provides a rotary shaft assembly 100 used for a foldable electronic device 300, which can rotate automatically to drive the foldable electronic device 300 to automatically switch from a closed state to an open state, that is, the foldable electronic device 300 automatically pops up from the closed state to the open state. Therefore, it is more convenient and effort-saving during use.

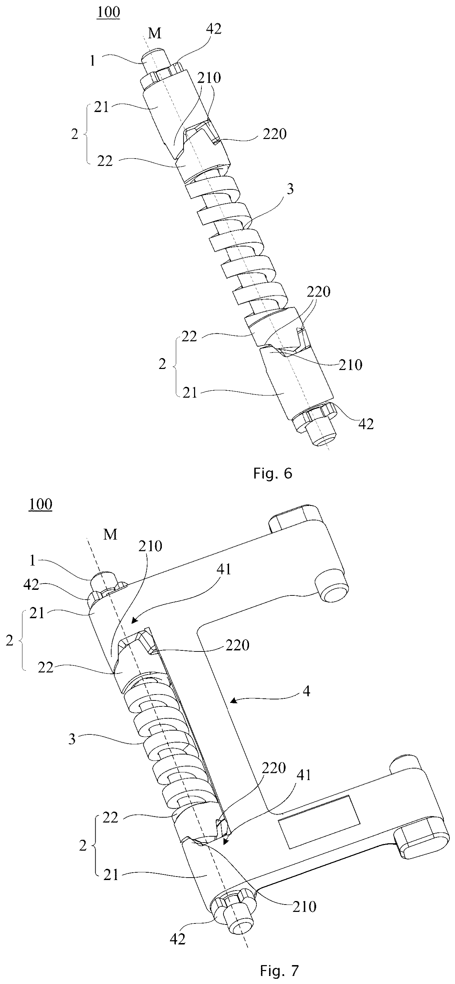

Referring to FIG. 6 and FIG. 7, FIG. 6 is a schematic diagram of a three-dimensional structure of a rotary shaft assembly according to an embodiment of this application; and FIG. 7 is a schematic diagram of a three-dimensional structure of a rotary shaft assembly in another implementation according to an embodiment of this application.

As shown in FIG. 6 and FIG. 7, the rotary shaft assembly 100 includes a connecting shaft 1 and at least one cam group 2. In an implementation, the connecting shaft 1 may be fastened relative to the base 50 of the hinge apparatus 200. In another alternative implementation, the connecting shaft 1 may rotate around an axis of the connecting shaft 1 relative to the base 50 of the hinge apparatus 200.

Further, each cam group 2 includes a first cam 21 and a second cam 22 that are in mutual contact and extrusion. The first cam 21 and the second cam 22 are sequentially sleeved on the connecting shaft 1 in a direction of an axis M of the connecting shaft, and are configured to: be capable of generating relative rotation around the axis M of the connecting shaft, and be capable of generating relative movement in the direction of the axis M of the connecting shaft, so that the first cam 21 can move switching between a first position and a second position relative to the second cam 22. The first cam 21 and the second cam 22 may generate relative rotation around the axis M of the connecting shaft, and any of the cams may rotate around the connecting shaft 1.

In an implementation, the first cam 21 is rotatably connected to the connecting shaft 1, and the second cam 22 is unrotatably disposed on the connecting shaft 1 (that is, cannot rotate relative to the connecting shaft 1). In another alternative implementation, the first cam 21 may be unrotatably connected to the connecting shaft 1, and the second cam 22 is rotatably connected to the connecting shaft 1. This is not limited in this application.

A person skilled in the art may understand that a specific form of the first cam 21 is not limited. As shown in FIG. 7, in an implementation, one end of the damping swing arm 4 has a rotating part 41, and the rotating part 41 is configured as the first cam 21, that is, the damping swing arm 4 is integrally formed with each first cam 21 on the rotary shaft assembly 100 on which the damping swing arm is located. A specific structure of the rotating part 41 is not limited. For example, the rotating part may be a sleeve, and the damping swing arm 4 is directly sleeved on the connecting shaft 1 through the sleeve. In another alternative implementation, the first cam 21 may be independently disposed (as shown in FIG. 6), and is then connected to the damping swing arm 4 or another component in a form of welding, bonding, screwing, or the like (for example, when the rotary shaft assembly 100 is applied to a notebook computer, the damping swing arm may not be disposed in the rotary shaft assembly 100, and the first cam 21 is independently disposed, and may be connected to a housing on a side on which a display screen of the notebook computer is located or a housing on a side on which a keyboard is located). This is not limited in this application.

A person skilled in the art may understand that a manner in which the first cam 21 and the second cam 22 are in mutual contact and extrusion is not limited. In an implementation, the rotary shaft assembly 100 further includes an elastic member 3. The elastic member 3 is sleeved on the connecting shaft 1 and abuts against one of the first cam 21 and the second cam 22, and the other cam is relatively fixed relative to the connecting shaft 1 in the direction of the axis M of the connecting shaft. The elastic member 3 applies elastic force to one of the cams through of deformation of the elastic member, so that one of the cams and the other cam are in mutual contact and extrusion (that is, the first cam 21 and the second cam 22 are in mutual contact and extrusion). A specific position of the elastic member 3 is not limited, and the elastic member may abut against the first cam 21, or may abut against the second cam 22. In an implementation, the elastic member 3 is disposed at an end that is of the second cam 22 and that is away from the first cam 21, that is, the second cam 22 is disposed between the elastic member 3 and the first cam 21 in the cam group 2, and the elastic member 3 abuts against the second cam 22. The first cam 21 is fastened relative to the connecting shaft 1 in an axial direction of the connecting shaft 1 (which may be understood as that the first cam 21 cannot slide relative to the connecting shaft 1 in the direction of the axis M of the connecting shaft), the second cam 22 is slidably connected to the connecting shaft 1 in the direction of the axis M of the connecting shaft, and the elastic member 3 presses against the second cam 22 through elastic force of the elastic member, so that the second cam 22 and the first cam 21 are in mutual extrusion.

In an alternative implementation, the elastic member 3 may be disposed at an end that is of the first cam 21 and that is away from the second cam 22, that is, the first cam 21 is disposed between the elastic member 3 and the second cam 22 in the cam group 2, and the elastic member 3 abuts against the first cam 21. The second cam 22 is fastened relative to the connecting shaft 1 in the axial direction of the connecting shaft 1 (which may be understood as that the second cam 22 cannot slide relative to the connecting shaft 1 in the direction of the axis M of the connecting shaft), the first cam 21 is slidably connected to the connecting shaft 1 in the direction of the axis M of the connecting shaft, and the elastic member 3 presses against the first cam 21 through elastic force of the elastic member, so that the first cam 21 and the second cam 22 are in mutual extrusion.

A manner in which the first cam 21 is fastened relative to the connecting shaft 1 in the direction of the axis M of the connecting shaft is not limited. In an implementation, an abutment part 42 is disposed on a side that is of the first cam 21 and that is away from the elastic member 3 in the axis M of the connecting shaft, the abutment part 42 is fastened relative to the connecting shaft 1 in the direction of the axis M of the connecting shaft, and the first cam 21 abuts against the abutment part 42 under extrusion force of the elastic member 3 and the second cam 22, so that the first cam 21 keeps fixed relative to the connecting shaft 1 in the axis M of the connecting shaft. A manner of fastening the abutment part 42 to the connecting shaft 1 is not limited. For example, a slot recessed inward may be disposed on the connecting shaft 1, and the abutment part 42 is clamped in the slot. A specific structure of the abutment part 42 is not limited. For example, a snap ring structure may be used. An installation position of the abutment part 42 is not limited, and the abutment part may be installed on the connecting shaft 1, or may be installed on the base 50 or the abutment seat 6, provided that the first cam 21 can be fastened relative to the connecting shaft 1 in the direction of the axis M of the connecting shaft.

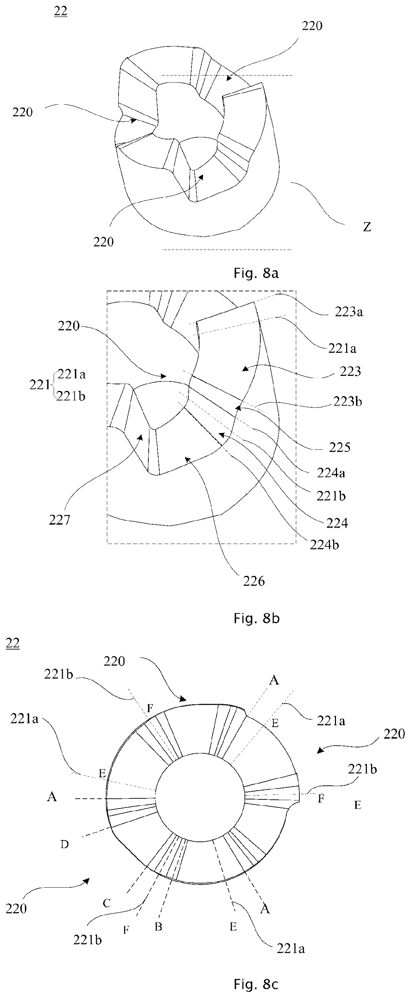

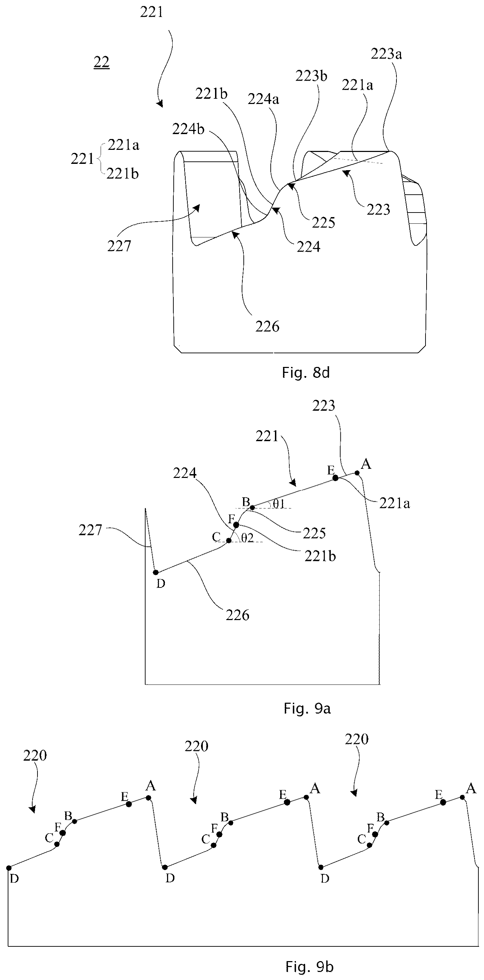

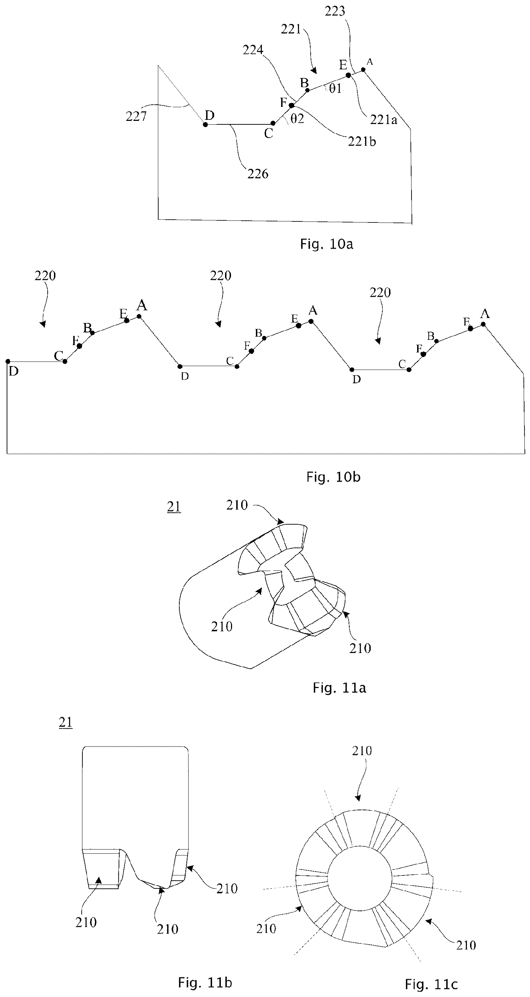

Referring to FIG. 8A-FIG. 10B, FIG. 8A-FIG. 8D are schematic diagrams of structures of a second cam in a rotary shaft assembly according to an embodiment of this application, where FIG. 8B is a locally enlarged view of a part Z in FIG. 8A; FIG. 9A is a schematic diagram of a 120° structure in which a second cam in a rotary shaft assembly expands in a circumferential direction according to an embodiment of this application; FIG. 9B is a schematic diagram of a 360° structure in which a second cam in a rotary shaft assembly expands in a circumferential direction according to an embodiment of this application; FIG. 10A is a schematic diagram of a 120° structure in which a second cam in a rotary shaft assembly expands in a circumferential direction in another implementation according to an embodiment of this application; and FIG. 10B is a schematic diagram of a 360° structure in which a second cam in a rotary shaft assembly expands in a circumferential direction in another implementation according to an embodiment of this application.

As shown in FIG. 8A-FIG. 10B, at least one protruding part 210 (refer to FIG. 11A-FIG. 12B) protruding outward in the direction of the axis M of the connecting shaft is disposed on an end surface that is of the first cam 21 and that faces the second cam 22, and at least one recessed part 220 recessed inward in the direction of the axis M of the connecting shaft is disposed on an end surface that is of the second cam 22 and that faces the first cam 21. The protruding part 210 is in a one-to-one correspondence with the recessed part 220. Each recessed part 220 has a sliding surface 221 (that is, an EF surface in FIG. 9A-FIG. 10B) for sliding by a corresponding protruding part 210, so that when the first cam 21 moves switching between the first position and the second position relative to the second cam 22, each protruding part 210 always slides on the sliding surface 221 of a corresponding recessed part 220. Alternatively, this may be understood as that, in a process of relative rotation between the first cam 21 and the second cam 22, there is always a part that is of the protruding part 210 on the first cam 21 and that is in contact with the sliding surface 221 on the corresponding recessed part 220.

Further, the sliding surface 221 is configured to be inclined relative to a plane perpendicular to the axis M of the connecting shaft. In addition, as shown in FIG. 8B-FIG. 9A and FIG. 10A, the sliding surface 221 has a first end 221a and a second end 221b, and a surface between the first end 221a and the second end 221b forms the sliding surface 221. For ease of understanding, in FIG. 9A-FIG. 10B, E represents the first end 221a, F represents the second end 221b, and the sliding surface 221 may be understood as an EF surface. From the first end 221a to the second end 221b, the sliding surface 221 extends toward a direction away from the first cam 21 in the direction of the axis M of the connecting shaft (which may alternatively be understood as follows: from the first end 221a to the second end 221b, a distance between the sliding surface 221 and an end surface that is of the second cam 22 and that is away from the of the first cam 21 gradually decreases in the direction of the axis M of the connecting shaft). When the first cam 21 is in the first position relative to the second cam 22, each protruding part 210 abuts against the first end 221a of the sliding surface 221 of the corresponding recessed part 220, and the foldable electronic device 300 is in the closed state. When the first cam 21 is in the second position relative to the second cam 22, each protruding part 210 abuts against the second end 221b of the sliding surface 221 of the corresponding recessed part 220, and the foldable electronic device 300 is in the open state. The plane perpendicular to the axis M of the connecting shaft may be understood as a plane in a radial direction of the connecting shaft 1, and the sliding surface 221 is inclined relative to the plane.

According to the rotary shaft assembly 100 provided in this application, the first cam 21 and the second cam 22 can rotate relative to each other, and drive the first housing 81 and the second housing 82 of the foldable electronic device 300 to rotate relative to each other, to switch between the closed state and the open state. An uneven concave-convex structure is designed on end surfaces that are of the first cam 21 and the second cam 22 and that are opposite to each other. The protruding part 210 protruding outward is disposed on the first cam 21, and the recessed part 220 recessed inward is disposed on the second cam 22. When the two cams rotate relative to each other, the protruding part 210 slides on the sliding surface 221 in the recessed part 220 corresponding to the protruding part, and damping force changes through design of the sliding surface 221.

The sliding surface 221 is inclined relative to the plane perpendicular to the axis M of the connecting shaft, and from the first end 221a to the second end 221b, the sliding surface 221 extends toward the direction away from the first cam 21 in the direction of the axis M of the connecting shaft, that is, the sliding surface 221 is a surface inclined relative to the radial direction of the connecting shaft 1, and from the first end 221a to the second end 221b, the sliding surface 221 always extends toward the direction away from the first cam 21. This may be understood as that a process in which a cam slides from the first end 221a to the second end 221b along the sliding surface 221 is always a downhill path. In this structure, when the foldable electronic device 300 is in the closed state, the protruding part 210 abuts against the first end 221a of the sliding surface 221. Because elastic force of the elastic member 3 causes mutual extrusion between the first cam 21 and the second cam 22, the protruding part 210 has a tendency of moving toward the second cam 22. In this case, as long as locking force that keeps the foldable electronic device 300 in the closed state is released (for example, a locking structure is switched from a locked state to an unlocked state), the protruding part 210 on the first cam 21 automatically slides from the first end 221a to the second end 221b along the downhill path, the first cam 21 rotate from the first position to the second position relative to the second cam 22, and the foldable electronic device 300 automatically switches from the closed state to the open state.

Therefore, the first cam 21 and the second cam 22 in the rotary shaft assembly 100 provided in this embodiment of this application can automatically rotate relative to each other from the first position to the second position, so that the foldable electronic device 300 can automatically switch from the closed state to the open state, that is, the foldable electronic device 300 automatically pops up from closed state to the open state. Therefore it is more convenient and effort-saving during use.

It may be understood by a person skilled in the art that, when the first cam 21 moves from the first position to the second position relative to the second cam 22, an angle of relative rotation between the first cam 21 and the second cam 22 is not limited. For example, the angle may be any angle within 85°-95° (for example, 85°, 90°, or 95°), or may be less than 85°, or may be greater than 95°. This is not limited in this application. In an implementation, when the first cam 21 moves from the first position to the second position relative to the second cam 22, an angle of relative rotation between the first cam 21 and the second cam 22 is 90°, each damping swing arm 4 rotates 90° under driving by the corresponding first cam 21, and two damping swing arms 4 in each group of symmetrical rotary shaft assemblies 100 respectively rotate 90° relative to the base 50, so that the two damping swing arms 4 rotate 180° relative to each other, and the first housing 81 and the second housing 82 of the foldable electronic device 300 are opened at 180° relative to each other.

It may be understood by a person skilled in the art that a quantity of cam groups 2, a quantity of protruding parts 210 on the first cam 21, and a quantity of recessed parts 220 on the second cam 22 all are not limited.

In an implementation, two cam groups 2 are disposed in one rotary shaft assembly 100, and the two cam groups 2 are respectively located at two ends of the elastic member 3. The elastic member 3 simultaneously provides mutual extrusion force between the first cam 21 and the second cam 22 for the two cam groups 2. The two damping swing arms 4 connected to the first housing 81 and the second housing 82 may be simultaneously connected to the first cams 21 in the two cam groups 2, and synchronous rotation of the two first cams 21 drives rotation of the damping swing arms 4.

In an implementation, three protruding parts 210 (refer to FIG. 11A-FIG. 12B) are evenly disposed at intervals on each first cam 21 in a circumferential direction of the first cam 21, and three recessed parts 220 are evenly disposed at intervals on each second cam 22 in a circumferential direction of the second cam 22, that is, in each cam group 2, there are three pairs of protruding parts 210 and recessed parts 220 that fit with each other. In this way, an area of contact between the first cam 21 and the second cam 22 can be increased, and the first cam and the second cam are more stable when rotating relative to each other. In another alternative implementation, one or more than two cam groups 2 may be disposed in the rotary shaft assembly 100, and each cam group 2 may be provided with fewer than or more than three pairs of protruding parts 210 and recessed parts 220. This is not limited in this application.

It may be understood by a person skilled in the art that, a specific structure of the sliding surface 221 on the recessed part 220 is not limited. For example, the sliding surface may be an inclined plane, a curved surface, an arc surface, or a surface formed by splicing several of an inclined plane, a curved surface, and an arc surface, provided that the sliding surface is inclined relative to the plane perpendicular to the axis M of the connecting shaft, and extends, from the first end 221a to the second end 221b, toward the direction away from the first cam 21 in the direction of the axis M of the connecting shaft. The following describes, with reference to the accompanying drawings by using an example, a structure that may be used for the sliding surface 221.

As shown in FIG. 8B and FIG. 9A-FIG. 10B, in an implementation, the recessed part 220 includes a first inclined surface 223 and a second inclined surface 224 that are connected. The first inclined surface 223 has a first end 223a and a second end 223b, and in FIG. 8B and FIG. 8D, a surface between the first end 223a and the second end 223b represents the first inclined surface 223. The second inclined surface 224 has a first end 224a and a second end 224b, and in FIG. 8B and FIG. 8D, a surface between the first end 224a and the second end 224b represents the second inclined surface 224. For ease of understanding, in FIG. 9A-FIG. 10B, A represents the first end 223a of the first inclined surface 223, C represents the second end 224b of the second inclined surface 224, and B represents a junction between the first inclined surface 223 and the second inclined surface 224. The second end 223b of the first inclined surface 223 and the first end 224a of the second inclined surface 224 may simultaneously overlap with B, or may be respectively located on two sides of B.

Both the first inclined surface 223 and the second inclined surface 224 are inclined relative to the plane perpendicular to the axis M of the connecting shaft, the first end 221a of the sliding surface 221 is located on the first inclined surface 223, the second end 221b of the sliding surface 221 is located on the second inclined surface 224, and a surface that is in the first inclined surface 223 and the second inclined surface 224 and that is located between the first end 221a and the second end 221b forms the sliding surface 221. Alternatively, this may be understood as that the sliding surface 221 includes two surfaces with different inclined angles, that is, a whole or a part of the first inclined surface 223 and a whole or a part of the second inclined surface 224. Because phases in which the foldable electronic device 300 switches between the open state and the closed state have different requirements for a hand feeling, a design structure that divides the sliding surface 221 into two inclined surfaces facilitates hand feeling design in the phases.

Inclined angles of the first inclined surface 223 and the second inclined surface 224 are not limited. In an implementation, an angle at which the first inclined surface 223 is inclined relative to the plane perpendicular to the axis M of the connecting shaft is 10°-15°, for example, may be 10°, 12°, 15°, or the like; and an angle at which the second inclined surface 224 is inclined relative to the plane perpendicular to the axis M of the connecting shaft is 60°-65°, for example, may be 60°, 63°, 65°, or the like. In other words, in FIG. 9A and FIG. 10A, a range of an angle θ1 is 10°-15°, and a range of an angle θ2 is 60°-65°. When the foldable electronic device 300 is in the open state, the first cam 21 is in the second position relative to the second cam 22, and the protruding part 210 fits with the second inclined surface 224. A relatively large inclined angle is designed for the second inclined surface 224, which can prevent the protruding part 210 from moving toward the first end 221a of the sliding surface 221 along the second inclined surface 224 under slight external force (for example, bump and vibration of the foldable electronic device 300), resulting in accidental switching of the foldable electronic device 300 to the closed state, that is, force for keeping the foldable electronic device 300 in the open state is increased. In addition, a relatively small inclined angle is designed for the first inclined surface 223, so that it is relatively effort-saving when the protruding part 210 moves toward the second end 221b of the sliding surface 221 on the second inclined surface 224, and it is relatively effort-saving in a later phase in which the foldable electronic device 300 switches from the open state to the closed state. Therefore, this structure has an effect of automatic rotation between the first cam 21 and the second cam 22, retaining force generated when the first cam 21 is in the second position, and a hand feeling generated when the first cam 21 rotates toward the first position. In another alternative implementation, the angle at which the first inclined surface 223 is inclined relative to the plane perpendicular to the axis M of the connecting shaft may be less than 10 degrees or greater than 15°, and the angle at which the second inclined surface 224 is inclined relative to the plane perpendicular to the axis M of the connecting shaft may be less than 60 degrees or greater than 65°. This is not limited in this application.

It should be noted that a manner of transition between the first inclined surface 223 and the second inclined surface 224 is not limited. As shown in FIG. 8B-FIG. 9A, in an implementation, the first inclined surface 223 and the second inclined surface 224 are connected by using a first arc surface 225, so that sliding of the protruding part 210 between the first inclined surface 223 and the second inclined surface 224 is continuous relatively smoothly. As shown in FIG. 10A-FIG. 10B, in another alternative implementation, the first inclined surface 223 and the second inclined surface 224 may be directly connected. This is not limited in this application.

It may be understood by a person skilled in the art that a position of the junction (that is, B in FIG. 9A-FIG. 10B, where when the first inclined surface 223 and the second inclined surface 224 are connected by using the first arc surface 225, B is located on the first arc surface 225; or when the first inclined surface 223 and the second inclined surface 224 are directly connected, B is located on an intersection line of the first inclined surface 223 and the second inclined surface 224) between the first inclined surface 223 and the second inclined surface 224 not limited. In an implementation, when the protruding part 210 of the first cam 21 moves along the recessed part 220 from the second end 221b of the sliding surface 221 to the junction between the first inclined surface 223 and the second inclined surface 224 (that is, from E to B), an angle of relative rotation between the first cam 21 and the second cam 22 is 20°-30°, for example, may be 20°, 24°, 26°, or 30°. Because the inclined angle of the second inclined surface 224 is relatively large, it is relatively laborious for the protruding part 210 to move on the second inclined surface 224. This part is designed as a relatively short route to reduce phases are laborious in a process of relative rotation between the first cam 21 and the second cam 22. In another alternative implementation, when the protruding part 210 of the first cam 21 moves along the recessed part 220 from the second end 221b of the sliding surface 221 to the junction between the first inclined surface 223 and the second inclined surface 224, an angle of relative rotation between the first cam 21 and the second cam 22 may be less than 20° or greater than 30°. This is not limited in this application.

It may be understood by a person skilled in the art that, the first end 221a of the sliding surface 221 may be located in any position of the first inclined surface 223, and the second end 221b may also be located in any position of the second inclined surface 224. For example, the first end 221a may be located between the two ends of the first inclined surface 223 or at an endpoint (that is, the first end 221a of the sliding surface 221 may be located between the first end 223a and the second end 223b of the first inclined surface 223, or may be located at the first end 223a), and the second end 221b may also be located between the two ends of the second inclined surface 224 or at an endpoint (that is, the second end 221b of the sliding surface 221 may be located between the first end 224a and the second end 224b of the second inclined surface 224, or may be located at the second end 224b).

In an implementation, an end that is of the first inclined surface 223 and that is away from the second inclined surface 224 is disposed spaced apart from the first end 221a of the sliding surface 221, that is, a specific distance is reserved between the first end 221a of the sliding surface 221 and the first end 223a of the first inclined surface 223 as redundancy (which may be understood as that AE has a specific length). Similarly, an end that is of the second inclined surface 224 and that is away from the first inclined surface 223 is disposed spaced apart from the second end 221b of the sliding surface 221, that is, a specific distance is reserved between the second end 221b of the sliding surface 221 and the second end 224b of the second inclined surface 224 as redundancy (which may be understood as that CF has a specific length). In this structure, the protruding part 210 may slide on a part other than the sliding surface 221, thereby reducing a processing precision requirement of the second cam 22.

A person skilled in the art may understand that a redundant distance between each of the two ends of the sliding surface 221 and each of the two ends of the first inclined surface 223 and the second inclined surface 224 is not limited. In an implementation, when each protruding part 210 moves from the second end 221b of the sliding surface 221 to the second end 224b of the second inclined surface 224 (that is, from F to C) along the recessed part 220 corresponding to the protruding part, an angle of relative rotation between the first cam 21 and the second cam 22 is 3°-10°, that is, a redundant distance between the second end 221b and the second end 224b of the second inclined surface 224 is within a rotation route of 3°-10°. More specifically, the angle may be 5°, 7°, 8°, or the like. In an example, when the protruding part 210 moves from the second end 221b of the sliding surface 221 to the second end 224b of the second inclined surface 224 along the recessed part 220 corresponding to the protruding part, an angle of relative rotation between the first cam 21 and the second cam 22 is 5°. In another alternative implementation, the angle may be less than 3° or greater than 10°. This is not limited in this application.

It may be understood by a person skilled in the art that, a structure of each protruding part 210 on the first cam 21 is not limited, and a manner in which the protruding part 210 on the first cam 21 fits with the recessed part 220 on the second cam 22 is not limited, for example, may be a point fit (the protruding part 210 and the recessed part 220 are in point contact), a line fit (the protruding part 210 and the recessed part 220 are in line contact), or a surface fit (the protruding part 210 and the recessed part 220 are in surface contact). In an implementation, in a process in which the protruding part 210 moves from the first position to the second position, the protruding part 210 keeps in line contact with the sliding surface 221 of the corresponding recessed part 220, that is, the protruding part 210 always keeps in a line fit with the recessed part 220 corresponding to the protruding part, to reduce friction force between the first cam 21 and the second cam 22.

The following describes, with reference to the accompanying drawings by using an example, a structure that may be used for the protruding part 210 and a process in which the protruding part 210 fits with the recessed part 220.

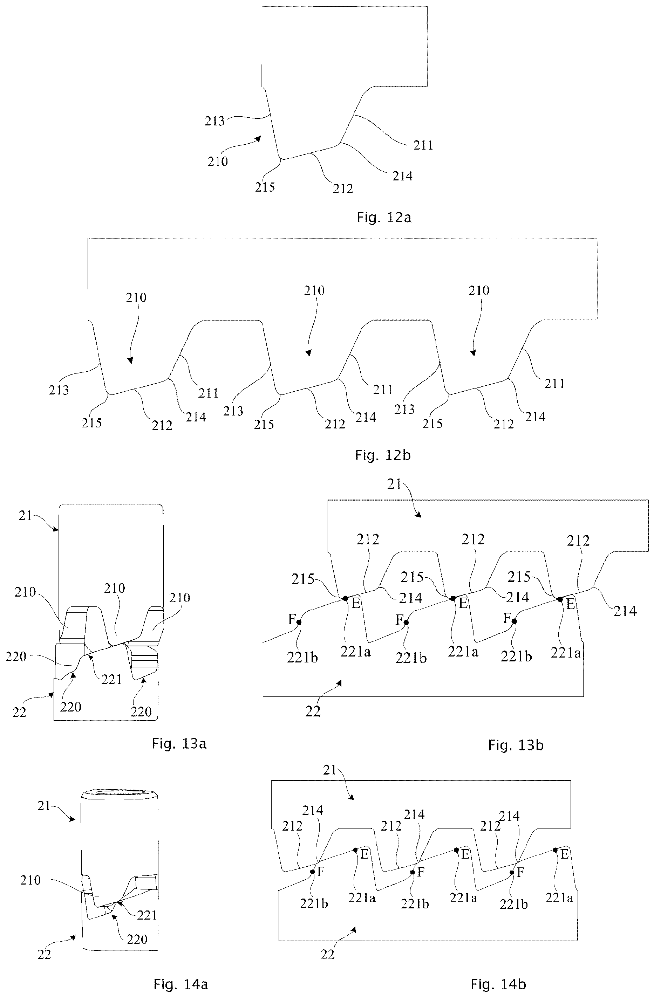

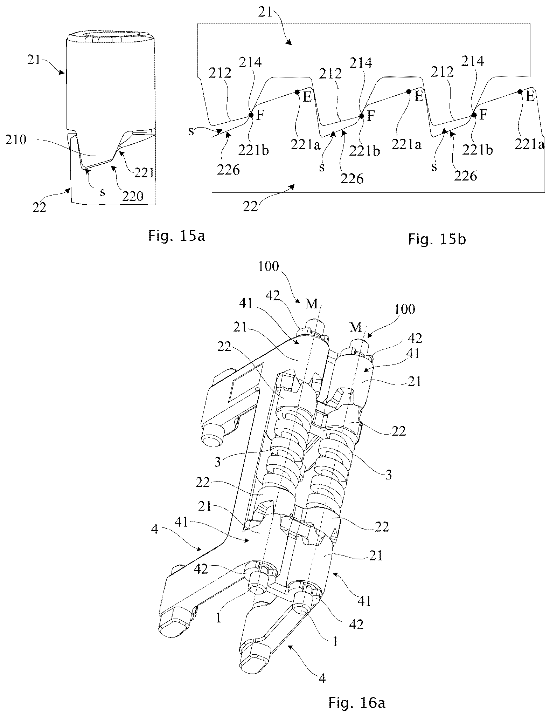

Referring to FIG. 11A-FIG. 15B, FIG. 11A-FIG. 11C are schematic diagrams of structures of a first cam in a rotary shaft assembly according to an embodiment of this application; FIG. 12A is a schematic diagram of a 120° structure in which a first cam in a rotary shaft assembly expands in a circumferential direction according to an embodiment of this application; FIG. 12B is a schematic diagram of a 360° structure in which a first cam in a rotary shaft assembly expands in a circumferential direction according to an embodiment of this application; FIG. 13A-FIG. 13B are schematic diagrams of fitting that is between a first cam and a second cam in a rotary shaft assembly and that is in a first position according to an embodiment of this application; FIG. 14A-FIG. 14B are schematic diagrams of fitting that is between a first cam and a second cam in a rotary shaft assembly and that is between a first position and a second position according to an embodiment of this application; and FIG. 15A-FIG. 15B are schematic diagrams of fitting that is between a first cam and a second cam in a rotary shaft assembly and that is in a second position according to an embodiment of this application.

As shown in FIG. 11A-FIG. 12B, in an implementation, the protruding part 210 has a first connection surface 211, a second connection surface 212, and a third connection surface 213 that are sequentially connected. The second connection surface 212 is located on a side that is of an end surface of the first cam 21 and that is close to the second cam 22, both one end of the first connection surface 211 and one end of the third connection surface 213 are connected to the end surface of the first cam 21, and the other ends are respectively connected to two ends of the second connection surface 212. It may be understood by a person skilled in the art that, specific types of the first connection surface 211, the second connection surface 212, and the third connection surface 213 are not limited, and each of the first connection surface, the second connection surface, and the third connection surface may be a plane, an arc surface, a curved surface, or a surface formed by splicing any several of a plane, an arc surface, and a curved surface.

It should be noted that, a manner of connection between the second connection surface 212 and the first connection surface 211 is not limited. For example, the second connection surface and the first connection surface may be directly connected, or may be connected by using a plane, a curved surface, an arc surface, or the like. In an implementation, the second connection surface 212 is connected to the first connection surface 211 by using a first curved surface 214, and in a process in which each protruding part 210 moves from the first position to the second position, the first curved surface 214 and the second connection surface 212 abut against the sliding surface 221 of the corresponding recessed part 220. The first curved surface 214 is a curved surface as a whole, and both the first inclined surface 223 and the second inclined surface 224 on the recessed part 220 are planes. Therefore, when the first curved surface 214 abuts against the sliding surface 221 (for example, the case shown in FIG. 14A-FIG. 15B), the first curved surface and the sliding surface may always keep in line contact. A curvature radius of the first curved surface 214 is not limited. In another alternative implementation, the first curved surface 214 may be an arc surface or the like. This is not limited in this application. In an implementation, the first connection surface 211 is a curved surface, and when the first connection surface 211 abuts against the sliding surface 221 (for example, the case shown in FIG. 13A-FIG. 13B), the first curved surface and the sliding surface may always keep in line contact. In another alternative implementation, the first connection surface 211 may be an arc surface, or a part that is of the first connection surface 211 and that is in contact with the sliding surface 221 is set to a curved surface or an arc surface, and the remaining part is set to a plane, or the like. This is not limited in this application.

A person skilled in the art may understand that a manner of connection between the second connection surface 212 and the third connection surface 213 is not limited. For example, the second connection surface and the third connection surface may be directly connected, or may be connected by using a plane, a curved surface, an arc surface, or the like. In an implementation, the second connection surface 212 is connected to the third connection surface 213 by using a second curved surface 215. In a process in which protruding part 210 moves from the first position to the second position, the second surface 215 may also abut against the sliding surface 221 of the corresponding recessed part 220, and a position in which the second curved surface 215 is connected to the second connection surface 212 may also abut against the sliding surface 221 of the corresponding recessed part 220. This is not limited in this application.

To describe more clearly a position in which each protruding part 210 fits with the corresponding recessed part 220 in a process of relative rotation between the first cam 21 and the second cam 22, the following uses a specific implementation as an example to describe the process of relative rotation between the first cam 21 and the second cam 22. As shown in FIG. 13A-FIG. 15B, in an implementation, when the first cam 21 is in the first position relative to the second cam 22 (as shown in FIG. 13A-FIG. 13B), the second connection surface 212 on each protruding part 210 is in contact with the first end 221a of the sliding surface 221 on the corresponding recessed part 220, and a position that is of the second connection surface 212 and that is in contact with the sliding surface 221 is close to the second curved surface 215. When the first cam 21 is in the second position relative to the second cam 22 (as shown in FIG. 15A-FIG. 15B), the first curved surface 214 on each protruding part 210 is in contact with the second end 221b of the sliding surface 221 on the corresponding recessed part 220. When the first cam 21 rotates from the first position to the second position relative to the second cam 22 (as shown in FIG. 14A-FIG. 14B), a part that is of each protruding part 210 and that is in contact with the sliding surface 221 gradually transitions from the second connection surface 212 to the first curved surface 214, and finally, the first curved surface 214 is in contact with the sliding surface 221. It should be noted that the foregoing process is merely an example, and the first cam 21 and the second cam 22 may also fit with each other in another manner when rotating relative to each other. For example, in a process in which the first cam 21 rotates from the first position to the second position relative to the second cam 22, the second curved surface 215, the second connection surface 212, and the first curved surface 214 on each protruding part 210 may be sequentially in contact with the sliding surface 221, or the first curved surface 214 may be always in contact with the sliding surface 221. This is not limited in this application.

As shown in FIG. 9A-FIG. 9B and FIG. 13A-FIG. 15B, in an implementation, the recessed part 220 further includes a bottom surface 226 (that is, a DC surface in FIG. 9A-FIG. 10B), and the bottom surface 226 is connected to the second end 224b of the second inclined surface 224. When the protruding part 210 abuts against the second end 221b of the sliding surface 221 of the recessed part 220, there is a gap s between the protruding part 210 and the bottom surface 226. Alternatively, this may be understood as that there is a gap s between the bottom surface 226 of the recessed part 220 and the second connection surface 212 of the protruding part 210.

It should be noted that a specific structure of the bottom surface 226 is not limited. In an implementation, the bottom surface 226 is configured as an inclined surface that is inclined relative to the plane perpendicular to the axis M of the connecting shaft. The second connection surface 212 may be the plane perpendicular to the axis M of the connecting shaft, or may be an inclined surface inclined relative to the plane perpendicular to the axis M of the connecting shaft. The bottom surface 226 and the second connection surface 212 are designed with different inclined angles, so that when the protruding part 210 abuts against the second end 221b of the sliding surface 221, there is a gap s between the bottom surface 226 and the protruding part 210. Lubricant grease may be added to the gap s, to reduce friction force in relative rotation between the first cam 21 and the second cam 22, so that a process of relative rotation between the first cam 21 and the second cam 22 is smoother.

As shown in FIG. 9A-FIG. 9B and FIG. 13A-FIG. 15B, in an implementation, the recessed part 220 further includes a side surface 227 (that is, an AD surface in FIG. 9B and FIG. 10B) that is connected to an end that is of the bottom surface 226 and that is away from the second inclined surface 224. When the protruding part 210 abuts against the second end 221b of the sliding surface 221 of the recessed part 220, the protruding part 210 further abuts against the side surface 227 of the recessed part 220, to limit relative rotation between the first cam 21 and the second cam 22. Alternatively, this may be understood as follows: When the first cam 21 rotates to the second position relative to the second cam 22, the first curved surface 214 of the protruding part 210 abuts against the second inclined surface 224 of the recessed part 220, and the third connection surface 213 of the protruding part 210 abuts against the side surface 227 of the recessed part 220, so that the entire protruding part 210 is clamped in the recessed part 220, to prevent continuous rotation between the first cam 21 and the second cam 22. In this case, a preset rotation angle is reached between the first cam 21 and the second cam 22, that is, the side surface 227 of the recessed part 220 plays a role of limiting a rotation route of the first cam 21.

The foregoing describes the specific structure of the rotary shaft assembly 100. The following describes, with reference to the accompanying drawings, a structure that may be used for a group of symmetrically disposed rotary shaft assemblies 100 when a plurality of groups of rotary shaft assemblies 100 are disposed in the hinge apparatus 200.

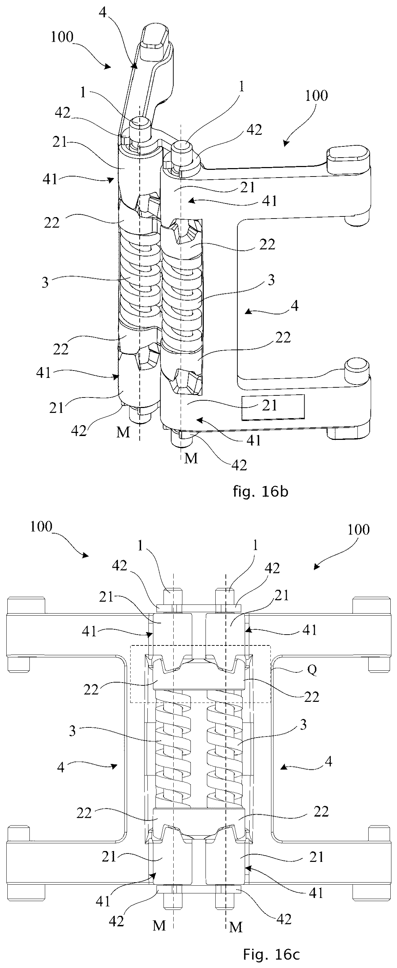

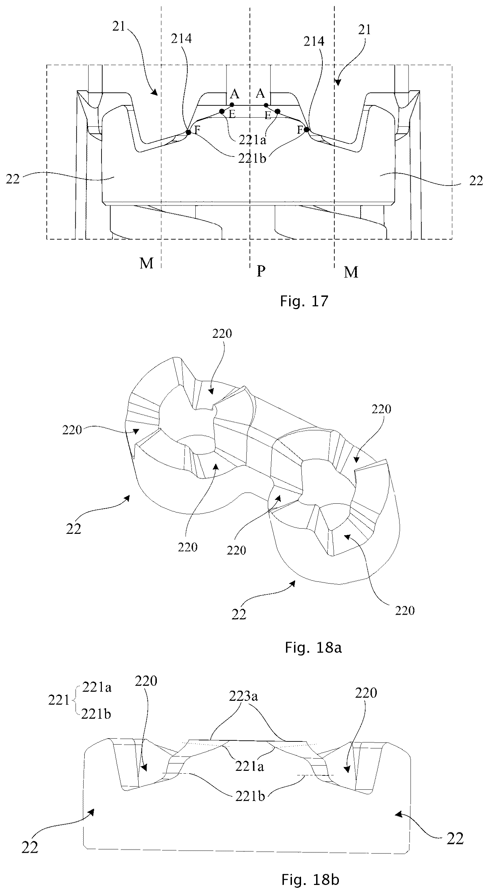

Referring to FIG. 16A-FIG. 18B, FIG. 16A-FIG. 16C are schematic diagrams of structures of a group of rotary shaft assemblies according to an embodiment of this application; FIG. 17 is a locally enlarged view of a part Q in FIG. 16C; and FIG. 18A-FIG. 18B are schematic diagrams of structures of two adjacent second cams in a group of rotary shaft assemblies according to an embodiment of this application.

As shown in FIG. 16A-FIG. 18B, in an implementation, two adjacent second cams 22 in each group of rotary shaft assemblies 100 are in an integrated structure, so that each second cam 22 is unrotatably disposed on the connecting shaft 1 on which the second cam is located. The two adjacent second cams 22 may be understood as two second cams 22 located on a same side of the elastic member 3 in the direction of the axis M of the connecting shaft. In another alternative implementation, the two adjacent second cams 22 in each group of rotary shaft assemblies 100 may alternatively be in a split structure, and the two cams are disposed independently of each other, or are fixedly connected in a manner of bonding, welding, screwing, or the like. This is not limited in this application.

As shown in FIG. 16A-FIG. 18B, in an implementation, the two adjacent second cams 22 in each group of rotary shaft assemblies 100 are axially symmetrically disposed, which may be understood as that recessed parts 220 of the two adjacent second cams 22 and sliding surfaces 221 of the recessed parts 220 are axially symmetrically distributed relative to an axis P. The axis P is an axis that is parallel to the axis M of the connecting shaft and that is located between the two adjacent second cams 22. Similarly, two first cams 21 corresponding to the two adjacent second cams 22 are also axially symmetrically disposed. Details are not described in this application. Through such disposing, hand feelings of rotation of two rotary shaft assemblies 100 may be more symmetrical. In another alternative implementation, the two adjacent second cams 22 and the two first cams 21 corresponding to the two adjacent second cams 22 may be asymmetrically disposed. This is not limited in this application.

As shown in FIG. 16A-FIG. 16C, in an implementation, two adjacent abutment parts 42 in each group of rotary shaft assemblies 100 may also be in an integrated structure. The two adjacent abutment parts 42 may be understood as two abutment parts 42 located on a same side of the elastic member 3 in the direction of the axis M of the connecting shaft. In another alternative implementation, the two adjacent abutment parts 42 in each group of rotary shaft assemblies 100 may be in a split structure, and the two abutment parts are disposed independently of each other, or are fixedly connected in a manner of bonding, welding, screwing, or the like. This is not limited in this application.

In conclusion, the rotary shaft assembly 100 provided in this application may automatically rotate from the first position to the second position, so that the foldable electronic device 300 can automatically switch from the closed state to the open state, which makes it more convenient and effort-saving during use.

Certainly, a person skilled in the art can make various modifications and variations to this application without departing from the spirit and scope of this application. In this way, this application is also intended to include these modifications and variations made to this application if they fall within the scope of the claims of this application and equivalent technologies thereof.

## Claims

1. A rotary shaft assembly used for a foldable electronic device, comprising:
a connecting shaft; and
at least one cam group, wherein each of the at least one cam group comprises a first cam and a second cam in mutual contact and extrusion, the first cam and the second cam are sequentially sleeved on the connecting shaft in a direction of an axis of the connecting shaft, and the first cam and the second cam are configured to: be capable of generating relative rotation around the axis of the connecting shaft, and be capable of generating relative movement in the direction of the axis of the connecting shaft, so that the first cam can move switching between a first position and a second position relative to the second cam, wherein
at least one protruding part protruding outward in the direction of the axis of the connecting shaft is disposed on an end surface that is of the first cam and that faces the second cam, and at least one recessed part recessed inward in the direction of the axis of the connecting shaft is disposed on an end surface that is of the second cam and that faces the first cam, wherein the at least one protruding part is in a one-to-one correspondence with the at least one recessed part, and each of the at least one recessed part has a sliding surface for sliding by a corresponding protruding part, so that when the first cam moves switching between the first position and the second position relative to the second cam, each of the at least one protruding part always slides on the sliding surface of a corresponding recessed part;
in addition, the sliding surface is configured to be disposed inclined relative to a plane perpendicular to the axis of the connecting shaft, the sliding surface has a first end and a second end, and from the first end to the second end, the sliding surface extends toward a direction away from the first cam in the direction of the axis of the connecting shaft; and
when the first cam is in the first position relative to the second cam, each of the at least one protruding part abuts against the first end of the sliding surface of the corresponding recessed part, and the foldable electronic device is in a closed state; and when the first cam is in the second position relative to the second cam, each of the at least one protruding part abuts against the second end of the sliding surface of the corresponding recessed part, and the foldable electronic device is in an open state.

2. The rotary shaft assembly according to claim 1, wherein each of the at least one recessed part comprises a first inclined surface and a second inclined surface that are connected, both the first inclined surface and the second inclined surface are inclined relative to the plane perpendicular to the axis of the connecting shaft, the first end of the sliding surface is located on the first inclined surface, the second end of the sliding surface is located on the second inclined surface, and a surface that is in the first inclined surface and the second inclined surface and that is located between the first end and the second end forms the sliding surface.

3. The rotary shaft assembly according to claim 2, wherein an angle at which the first inclined surface is inclined relative to the plane perpendicular to the axis of the connecting shaft is 10°-15°, and an angle at which the second inclined surface is inclined relative to the plane perpendicular to the axis of the connecting shaft is 60°-65°.

4. The rotary shaft assembly according to claim 2 or 3, wherein when each of the protruding parts of the first cam moves along the recessed part from the second end of the sliding surface to a junction between the first inclined surface and the second inclined surface, an angle of relative rotation between the first cam and the second cam is 20°-30°.

5. The rotary shaft assembly according to any one of claims 2-4, wherein the first inclined surface and the second inclined surface are connected by using a first arc surface.

6. The rotary shaft assembly according to any one of claims 2-5, wherein an end that is of the first inclined surface and that is away from the second inclined surface is disposed spaced apart from the first end of the sliding surface.

7. The rotary shaft assembly according to any one of claims 2-6, wherein an end that is of the second inclined surface and that is away from the first inclined surface is disposed spaced apart from the second end of the sliding surface.

8. The rotary shaft assembly according to claim 7, wherein when each of the protruding parts moves along the recessed part corresponding to the protruding part from the second end of the sliding surface to the end that is of the second inclined surface and that is away from the first inclined surface, an angle of relative rotation between the first cam and the second cam is 3°-10°.

9. The rotary shaft assembly according to any one of claims 2-8, wherein each of the recessed parts further comprises a bottom surface connected to the end that is of the second inclined surface and that is away from the first inclined surface, and when the protruding part abuts against the second end of the sliding surface of the recessed part, there is a gap between the protruding part and the bottom surface.

10. The rotary shaft assembly according to claim 9, wherein the recessed part further comprises a side surface that is connected to an end that is of the bottom surface and that is away from the second inclined surface, and when the protruding part abuts against the second end of the sliding surface of the recessed part, the protruding part further abuts against the side surface of the recessed part, to limit relative rotation between the first cam and the second cam.

11. The rotary shaft assembly according to claim 9 or 10, wherein the bottom surface is configured as an inclined surface that is inclined relative to the plane perpendicular to the axis of the connecting shaft.

12. The rotary shaft assembly according to any one of claims 1-11, wherein in a process in which each of the protruding parts moves from the first position to the second position, the protruding part keeps in line contact with the sliding surface of the corresponding recessed part.

13. The rotary shaft assembly according to claim 12, wherein the protruding part has a first connection surface, a second connection surface, and a third connection surface that are sequentially connected, the second connection surface is located on a side that is of an end surface of the first cam and that is close to the second cam, both one end of the first connection surface and one end of the third connection surface are connected to the end surface of the first cam, and the other ends are respectively connected to two ends of the second connection surface; and
the second connection surface is connected to the first connection surface by using a first curved surface, and in a process in which each of the protruding parts moves from the first position to the second position, the first curved surface and the second connection surface abut against the sliding surface of the corresponding recessed part.

14. The rotary shaft assembly according to any one of claims 1-13, wherein when the first cam moves from the first position to the second position relative to the second cam, an angle of relative rotation between the first cam and the second cam is 85°-95°.

15. The rotary shaft assembly according to any one of claims 1-14, wherein the at least one protruding part is three protruding parts evenly disposed at intervals in a circumferential direction of the first cam, and the at least one recessed part is three recessed parts evenly disposed at intervals in a circumferential direction of the second cam.

16. The rotary shaft assembly according to any one of claims 1-15, wherein the rotary shaft assembly further comprises an elastic member, and the elastic member is sleeved on the connecting shaft; and
the elastic member is disposed at an end that is of the first cam and that is away from the second cam, the second cam is fastened relative to the connecting shaft in the direction of the axis of the connecting shaft, and the elastic member is configured to apply elastic force to the first cam through deformation of the elastic member, so that the first cam and the second cam are in mutual contact and extrusion; or
the elastic member is disposed at an end that is of the second cam and that is away from the first cam, the first cam is fastened relative to the connecting shaft in the direction of the axis of the connecting shaft, and the elastic member is configured to apply elastic force to the second cam through deformation of the elastic member, so that the first cam and the second cam are in mutual contact and extrusion.

17. The rotary shaft assembly according to claim 16, wherein the at least one cam group is two cam groups respectively disposed at two ends of the elastic member, and the second cam in each of the two cam groups is disposed between the elastic member and the first cam in the cam group.

18. A hinge apparatus, comprising the rotary shaft assembly according to any one of claims 1-17.

19. A foldable electronic device, comprising a housing assembly, wherein the housing assembly comprises a first housing and a second housing, the housing assembly further comprises the hinge apparatus according to claim 18, and the first housing is rotatably connected to the second housing by using the hinge apparatus, so that the foldable electronic device can switch between the closed state and the open state.

20. The foldable electronic device according to claim 19, wherein the hinge apparatus comprises at least one group of the rotary shaft assemblies, each group of the rotary shaft assemblies comprises two rotary shaft assemblies symmetrically disposed, each of the rotary shaft assemblies further comprises a damping swing arm, one end of the damping swing arm has a rotating part, and the rotating part is configured as the first cam;
the other end of the damping swing arm of one rotary shaft assembly in each group of the rotary shaft assemblies is connected to the first housing, and the other end of the damping swing arm of the other rotary shaft assembly is connected to the second housing; and
the foldable electronic device further comprises a locking mechanism, wherein when the locking mechanism is in a locked state, the first housing and the second housing are stacked and kept relatively fixed, and when the locking mechanism is in an unlocked state, the first housing and the second housing can rotate relative to each other.

21. The foldable electronic device according to claim 19 or 20, wherein the foldable electronic device further comprises a display screen, and the display screen is laid on a side of the housing assembly; and when the foldable electronic device is in the closed state, the display screen surrounds the outside of the housing assembly.
